# EUROPEAN PATENT APPLICATION

(11) **EP 2 023 385 A1**
(43) Date of publication of application: **11.02.2009**
(21) Application number: 07743868.7
(22) Date of filing: 22.05.2007
(51) Int. Cl.: H01L 21/60, H01L 21/52, H01L 21/603

(54) **THERMOCOMPRESSION BONDING HEAD AND MOUNTING DEVICE USING THE SAME**

(30) Priority: 01.06.2006 JP 2006153750
(71) Applicant: Sony Chemical & Information Device Corporation, Tokyo 141-0032 (JP)
(72) Inventor: FURUTA, Kazutaka, Kanuma-shi, Tochigi 322-8503 (JP); TANIGUCHI, Masaki, Kanuma-shi, Tochigi 322-8503 (JP)
(74) Representative: Lloyd, Patrick Alexander Desmond
(86) International application number: PCT/JP2007/060434
(87) International publication number: WO 2007/138927

(57) **Abstract**

The present invention provides a thermocompression bonding head capable of mounting an electric component on a wiring board in a short time with high connection reliability, and provides a mounting device using the same. A thermocompression bonding head 3 includes a heatable metal head body 5 having an elastic pressure-bonding member 7 made of elastomer and a metal pressing member 5b. The metal pressing member 5b, corresponding to an electric component 20 as a target to be bonded with pressure, is provided as a united body with the head body 5, and the elastic pressure-bonding member 7 is attached to the head body 5 such that a pressing surface 50 of the metal pressing member 5b is exposed in a recessed state on the periphery of the metal pressing member 5b. The head body 5 is made of a frame-shaped member having a concave portion 5a, and the metal pressing member 5b is integrally formed in the concave portion 5a of the head body 5. Further, the elastic pressure-bonding member 7 is housed and attached in the concave portion 5a.

## Description

### Technical Field

The present invention relates to a technology for mounting a variety of electric components. More particularly, the present invention relates to a thermocompression bonding head for mounting an electric component using an adhesive agent and to a mounting device using the same.

### Background Art

Generally, in a case where a passive component such as a resistor and a capacitor is mounted on a wiring board, solder serving as a connecting material is melted in a reflow furnace so as to mount the passive component.

On the other hand, in a case where an electric component such as an IC chip is mounted on a wiring board, the electric component is packaged and mounted by solder, or the IC chip is directly placed on the wiring board and mounted by wire bonding or flip chip.

In a case where such an electric component is mounted by the flip chip using a conductive adhesive agent and the like, a hard pressure-bonding head made of metal and/or ceramic and the like is generally used to perform thermocompression boding.
In recent years, however, a pressure-bonding head made of a member having elasticity such as silicone rubber is also used to perform the thermocompression bonding

In a case where such an elastic member is used as the pressure-bonding head, there is an advantage that not only a plurality of electric components having different heights can be bonded with pressure, but also a variety of different electric components such as the resistor and the capacitor in addition to the IC chip can be collectively bonded with the pressure in a simultaneous manner (e.g., patent document 1).

However, in a case where the pressure-bonding head made of the metal and/or ceramic is used, insufficient heat with respect to a fillet portion of the adhesive agent on the periphery of the electric component generates a void in the course of the thermocompression bonding, causing a problem of deteriorating connection reliability.
On the other hand, in a case where the pressure-bonding head made of the elastic member described above is used, heat from a side of the pressure-bonding head is not adequate, causing a problem of prolonging a time for mounting.
Patent Document: Japanese Patent Laid-Open Publication 2005-32952

### Disclosure of the Invention

### Problems to be Solved by the Invention

The present invention is proposed in consideration of the aforementioned conventional situations. Moreover, the object of the present invention is intended to provide a thermocompression bonding head, which can mount an electric component on a wiring board in a short time with high connection reliability, and to provide a mounting device using the same.

### Means for Solving the Problem

To achieve the aforementioned objects, a thermocompression bonding head according to the present invention includes: a head body, made of heatable metal, having an elastic pressure-bonding member made of elastomer; and a metal pressing member, corresponding to an electric component as a target to be bonded with pressure, provided as a united body with the head body. The elastic pressure-bonding member is attached to the head body such that a pressing surface of the metal pressing member is exposed in a recessed state on a periphery of the metal pressing member.
In the thermocompression bonding head of the present invention, the head body is made of a frame-shaped member having a housing portion of a concave shape, the metal pressing member is integrally formed in the housing portion of the head body, and the elastic pressure-bonding member is housed in the housing portion.
In the thermocompression bonding head of the present invention, a size of the pressing surface of the metal pressing member is arranged to be slightly smaller than a size of a pressed surface of the electric component.
In the thermocompression bonding head of the present invention, a height difference between the pressing surface of the metal pressing member and a surface of the elastic pressure-bonding member is arranged to be greater than a thickness of the electric component.
In the thermocompression bonding head of the present invention, a portion on the periphery of the metal pressing member of the elastic pressure-bonding member is formed in a taper shape toward an outward of an opening of the metal pressing member.
Moreover, a mounting device according to the present invention includes: a base placeable a wiring board thereon; and any one of the thermocompression bonding heads described above disposed opposite to the base. The mounting device is provided such that the thermocompression bonding head is pressed with prescribed pressure with respect to the electric component placed on the wiring board on the base.

In a case of the mounting device of the present invention, the metal pressing member, corresponding to the electric component as a target to be bonded with pressure, is provided as a united body with the head body, and the elastic pressure-bonding member made of the elastomer is attached to the head body such that a pressing surface of the metal pressing member is exposed in a recessed state on a periphery of the metal pressing member. In the way, the heat and pressure is applied by the metal pressing member in close contact with respect to the pressed surface (top region) of the electric component while applying the pressure and heat by the elastic pressure-bonding member with respect to the fillet portion of the adhesive agent on the periphery. Consequently, the electric component is thermally compressed in a short time, and the thermocompression bonding can by performed with respect to the fillet portion of the adhesive agent on the periphery of the electric component so as not to generate the void, thereby allowing connection of the electric component with high reliability by using the adhesive agent.

In the present invention, where the head body is made of a frame-shaped member having a housing portion of a concave shape, where the metal pressing member is integrally formed in the housing portion of the head body, and where the elastic pressure-bonding member is housed in the housing portion, the thermocompression bonding head capable of surely attaching the elastic pressure-bonding member to the head body with a simple structure can be obtained.

In the present invention, in a case where a size of the pressing surface of the metal pressing member is arranged to be slightly smaller than a size of a pressed surface of the electric component, the pressure and heat is surely applied by the elastic pressure-bonding member with respect to a fillet portion of an adhesive agent on the periphery of the electric component, thereby reducing the generation of a void.

In the present invention, in a case where a height difference between the pressing surface of the metal pressing member and a surface of the elastic pressure-bonding member of the thermocompression bonding head is arranged to be greater than a thickness of the electric component, adequate pressure and heat is surely applied by the elastic pressure-bonding member with respect to the fillet portion of the adhesive agent on the periphery of the electric component, thereby reducing the generation of the void.

In the present invention, in a case where a portion on the periphery of the metal pressing member of the elastic pressure-bonding member is formed in a taper shape toward an outward of an opening of the metal pressing member, an opening on a pressing surface side of the elastic pressure-bonding member is sized greater than a top region of the electric component, so that the taper portion of the elastic pressure-bonding member contacts an edge of the pressed surface of the electric component in the course of the thermocompression bonding. Such a guidance movement allows the electric component to be smoothly in close contact with respect to the pressing surface of the metal pressing member. Also, the fillet portion of the adhesive agent on the periphery of the electric component is surely pressed by the edge of the taper portion of the elastic pressure-bonding member, thereby reducing the generation of the void.

### Advantages of the Invention

The present invention can provide a thermocompression bonding head, which can mount an electric component on a wiring board in a short time with high connection reliability, and can provide a mounting device using the same.

### Brief Description of the Drawings

Fig. 1 (a) is a schematic partial cross-sectional view illustrating a mounting device according to an embodiment of the present invention, and FIG. 1 (b) is a schematic diagram illustrating a pressing side of a thermocompression bonding head in the mounting device; and
Figs. 2 (a) and (b) are schematic diagrams illustrating a measurement relationship between a pressing surface of the thermocompression bonding head and a top port of an electric component.

### Explanation of Numerals

- 1:: Mounting device
- 2:: Base
- 3:: Thermocompression bonding head
- 5:: Head body
- 5a:: Concave portion (housing portion)
- 5b:: Metal pressing member
- 6:: Heater
- 7:: Elastic pressure-bonding member
- 7a:: Taper portion
- 8:: Opening
- 20:: Electric component
- 21:: Top region (surface to be pressed)
- 30:: Adhesive agent
- 50:: Pressing surface

### Best Mode for carrying out the Invention

Hereinafter, a thermocompression bonding head and a mounting device using the same according to an embodiment of the present invention will be explained in detail with reference to the drawings.

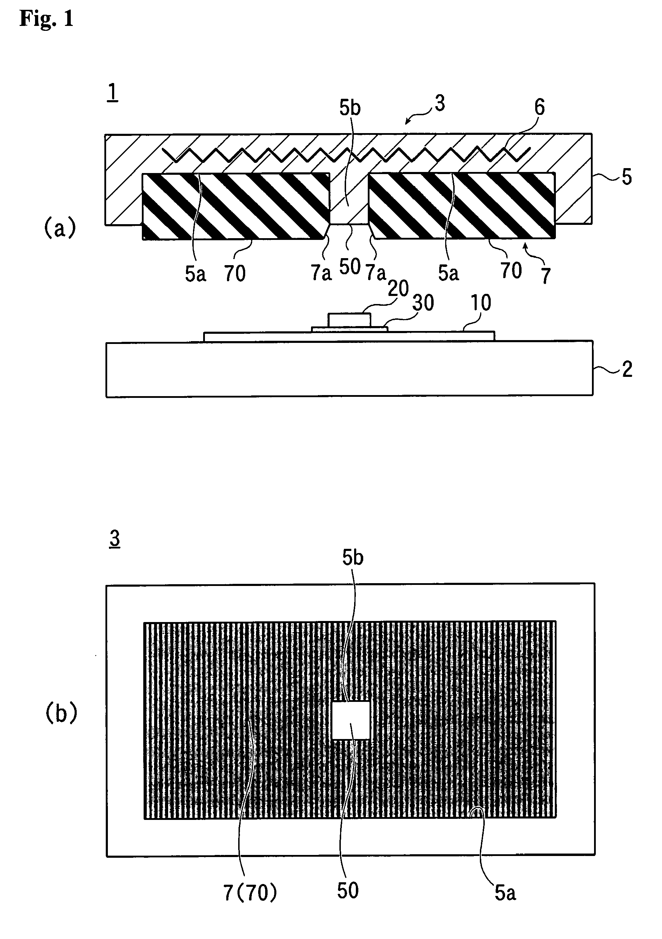

Fig. 1 (a) illustrates the mounting device according to the embodiment in a schematic partial cross-sectional view, and Fig. 1 (b) illustrates a pressing side of the thermocompression bonding head in the mounting device in a schematic diagram.

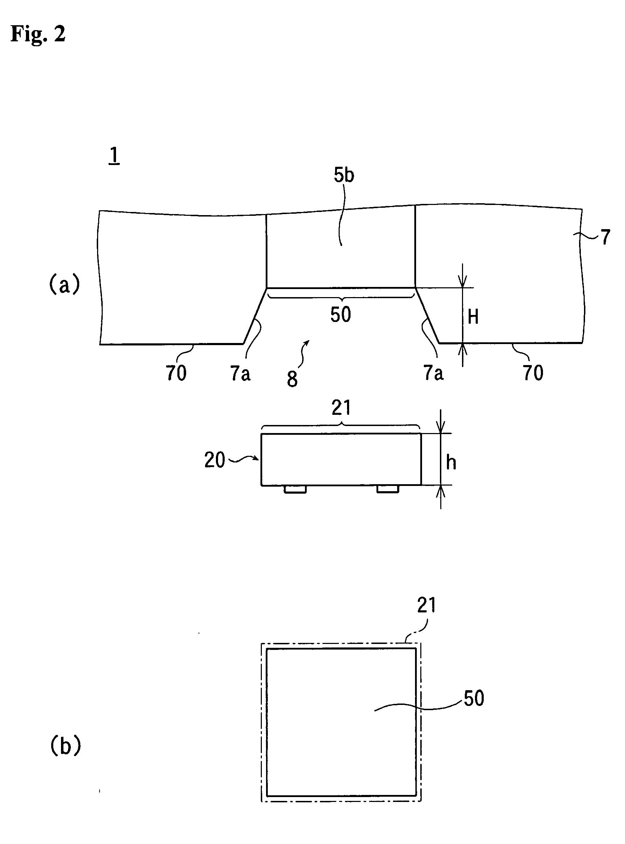

Figs. 2 (a) and (b) illustrate a measurement relationship between a pressing surface of the thermocompression bonding head and a top region of an electric component in schematic diagrams.

As illustrated in Figs. 1 (a) and (b), a mounting device 1 according to the embodiment includes a base 2 placing thereon a wiring board 10 having a wiring pattern (not shown) and a thermocompression bonding head 3 applying pressure and heat to an electric component 20 serving as a target to be thermally compressed such as an IC chip.

Herein, the base 2 is made of prescribed metal and includes a heater (not shown) for heating disposed inside thereof. The electric component 20 is in such a manner as to be disposed, through an adhesive agent 30, in a prescribed position on the wiring board 10 placed on the base 2.

In a case of the present invention, any one of an insulating adhesive agent and an anisotropic conductive adhesive agent can be used as the adhesive agent 30.
On the other hand, the thermocompression bonding head 3 includes a head body 5, for example, made of a metal material such as a stainless steel, and the head body 5 includes a heater 6 for heating disposed inside thereof.

The head body 5 of the embodiment is made of the metal member in a box frame shape, for example, and includes a concave portion 5a (housing part) that is disposed in a portion opposite to the base 2.
A metal pressing member 5b (described later) is, for example, integrally provided in the head body by integral molding in a position (e.g., in a middle portion in the embodiment) corresponding to the electric component of the concave portion 5a of the head body 5.

Moreover, in the concave portion 5a of the head body 5, an elastic pressing-bonding member 7 made of elastomer (silicone rubber and the like) in a plate shape, for example, is attached in such a manner as to be in close contact with the inside the concave portion 5a.

In a case of the present invention, the elastic pressing-bonding member 7 is attached so that a pressing surface 50 of the metal pressing member 5b is exposed in a recessed state with respect to a surface 70 of the elastic pressing-bonding member 7 on the periphery of the metal pressing member 5b.
The metal pressing member 5b of the embodiment is formed in a quadrangular prism shape and has the pressing surface 50 of a rectangular plane shape in an end portion thereof.

In a case of the present invention, a size of the pressing surface 50 of the metal pressing member 5b is not particularly limited. However, the size of the pressing surface 50 is preferably arranged to be slightly smaller than a size of a surface of the electric component 20 to be pressed from a standpoint in which the pressure and heat is surely applied by the elastic pressure-bonding member 7 in such a manner as not to generate a void with respect to a fillet portion of the adhesive agent 30 on the periphery of the electric component 20.

In a case of the embodiment, for example, a size (outside dimension) of the pressing surface 50 of the metal pressing member 5b is preferably arranged to be slightly smaller than a size (outside dimension) of a top region 21 (surface to be pressed) of the electric component 20 as illustrated in Figs. 2 (a) and (b).

In a case of the present invention, on the other hand, for example, a height difference "H" between the pressing surface 50 of the metal pressing member 5b and the surface 70 of the elastic pressure-bonding member 7 is preferably arranged to be greater than a thickness "h" of the electric component as illustrated in Figs. 2 (a) from a standpoint in which the pressure is surely applied in such a manner as not to generate the void with respect to the fillet portion of the adhesive agent 30 on the periphery of the electric component 20 although the present invention it is not particularly limited thereby.

Moreover, in a case of the present invention, a portion on the periphery of the metal pressing member 5b of the elastic pressure-bonding member is preferably formed in a taper shape toward an outward of an opening 8 from a standpoint in which the pressing surface 50 of the metal pressing member 5b is smoothly in close contact with respect to the top region 21 of the electric component 20, and the pressure is surely applied in such a manner as not to generate the void with respect to the fillet portion of the adhesive agent 30 on the periphery although the present invention it is not particularly limited thereby.

In other words, a taper portion 7a having a prescribed angle is formed in an opening wall surface portion of the elastic pressure-bonding member 7, and the opening 8 on the pressing surface 50 of the elastic pressure-bonding member 7 is sized greater than the top region 21 of the electric component 20, so that the taper portion 7a of the elastic pressure-bonding member 7 contacts an edge of the top region 21 of the electric component 20 in the course of the thermocompression bonding. Such a guidance movement allows the electric component 20 to be smoothly in close contact with respect to the pressing surface 50 of the metal pressing member 5b. The fillet portion of the adhesive agent 30 on the periphery of the electric component 20 is surely pressed by the edge of the taper portion 7a of the elastic pressure-bonding member 7, thereby reducing the generation of the void.

An angle of the taper portion 7a of the elastic pressure-bonding member 7 can be arranged as needed according to the sizes of the pressing surface 50 of the metal pressing member 5b and the top region 21 of the electric component 20 and the height "H" of the surface of the elastic pressure-bonding member 7 with respect to the pressing surface 50 of the metal pressing member 5b.

According to the embodiment described above, the metal pressing member 5b corresponding to the electric component 20 as the target to be thermally compressed is integrally provided in the head body 5, and the elastic pressure-bonding member 7 made of the elastomer is attached to the head body 5 such that the pressing surface 50 of the metal pressing member 5b is exposed in the recessed state on the periphery of the metal pressing member 5b. Therefore, the heat and pressure is applied by the metal pressing member 5b being in close contact with respect to the top region 21 of the electric component 20 while applying the pressure and heat by the elastic pressure-bonding member 7 with respect to the fillet portion of the adhesive agent 30 on the periphery. Consequently, the electric component 20 is thermally compressed in a short time, and the thermocompression bonding can by performed with respect to the fillet portion of the adhesive agent 30 on the periphery of the electric component 20 so as not to generate the void, thereby allowing connection of the electric component 20 with high reliability by using the adhesive agent 30.

Particularly, according to the embodiment, the head body 5 is made of a frame shaped member having the concave portion 5a, and the metal pressing member 5b is integrally formed inside the concave portion 5a of the head body 5. Since the elastic pressure-bonding member 7 is housed in the concave portion 5a, the thermocompression bonding head capable of surely attaching the elastic pressure-bonding member 7 to the head body 5 with a simple structure can be obtained.

Moreover, according to the embodiment, the size of the pressing surface 50 of the metal pressing member 5b is arranged to be slightly smaller than that of the top region 21 of the electric component 20. Therefore, the pressure and heat is surely applied by the elastic pressure-bonding member 7 with respect to the fillet portion of the adhesive agent 30 on the periphery of the electric component 20, thereby reducing the generation of the void.

The present invention is not limited to the embodiment described above, and numerous additional modifications and variation of the present invention are possible.
For example, one metal pressing member is provided to the head body in the above embodiment. However, the present invention is not limited thereto. A plurality of the metal pressing members may be provided to the head body, and a plurality of electric components may be simultaneously thermally compressed.

Also, dispositions and shapes of the metal pressing member and the pressing surface may be modified as needed according to the electric component to be the target of the thermocompression bonding.
Moreover, the present invention may be applied to a variety of the electric components such as an IC chip and a capacitor.

## Claims

1. A thermocompression bonding head comprising:
a head body, made of heatable metal, having an elastic pressure-bonding member made of elastomer; and
a metal pressing member, corresponding to an electric component as a target to be bonded with pressure, provided as a united body with the head body,
wherein the elastic pressure-bonding member is attached to the head body such that a pressing surface of the metal pressing member is exposed in a recessed state on a periphery of the metal pressing member.

2. The thermocompression bonding head according to claim 1, wherein the head body is made of a frame-shaped member having a housing portion of a concave shape,
wherein the metal pressing member is integrally formed in the housing portion of the head body, and
wherein the elastic pressure-bonding member is housed in the housing portion.

3. The thermocompression bonding head according to claim 1, wherein a size of the pressing surface of the metal pressing member is arranged to be slightly smaller than a size of a pressed surface of the electric component.

4. The thermocompression bonding head according to claim 1, wherein a height difference between the pressing surface of the metal pressing member and a surface of the elastic pressure-bonding member is arranged to be greater than a thickness of the electric component.

5. The thermocompression bonding head according to claim 1, wherein a portion on the periphery of the metal pressing member of the elastic pressure-bonding member is formed in a taper shape toward an outward of an opening of the metal pressing member.

6. A mounting device comprising:
a base placeable a wiring board thereon; and
a thermocompression bonding head disposed opposite to the base, the thermocompression bonding head including:
a head body, made of heatable metal, having an elastic pressure-bonding member made of elastomer; and
a metal pressing member, corresponding to an electric component as a target to be bonded with pressure, provided as a united body with the head body, the elastic pressure-bonding member being attached to the head body such that a pressing surface of the metal pressing member is exposed in a recessed state on a periphery of the metal pressing member,
wherein the thermocompression bonding head is pressed with prescribed pressure with respect to the electric component placed on the wiring board on the base.

7. The mounting device according to claim 6, wherein the head body of the thermocompression bonding head is made of a frame-shaped member having a housing portion of a concave shape,
wherein the metal pressing member is integrally formed in the housing portion of the head body, and
wherein the elastic pressure-bonding member is housed in the housing portion.

8. The mounting device according to claim 6, wherein a size of the pressing surface of the metal pressing member of the thermocompression bonding head is arranged to be slightly smaller than a size of a pressed surface of the electric component.

9. The mounting device according to claim 6, wherein a height difference between the pressing surface of the metal pressing member and a surface of the elastic pressure-bonding member of the thermocompression bonding head is arranged to be greater than a thickness of the electric component.

10. The mounting device according to claim 6, wherein a portion on the periphery of the metal pressing member of the elastic pressure-bonding member of the thermocompression bonding head is formed in a taper shape toward an outward of an opening of the metal pressing member.
